# EUROPEAN PATENT APPLICATION

(11) **EP 1 122 660 A2**
(43) Date of publication of application: **08.08.2001**
(21) Application number: 01300652.3
(22) Date of filing: 25.01.2001
(51) Int. Cl.: G06F 17/50

(54) **CPU core development support system, method for development support and recording medium storing a development support program thereof**

(30) Priority: 01.02.2000 JP 2000028902
(71) Applicant: Daihen Corporation, Osaka (JP); Roran Co., Osaka (JP)
(72) Inventor: Tanaka, Ryohei, c/o Daihen Corporation, Osaka (JP); Shigeki, Kenji, c/o Roran Co., Osaka (JP); Nakao, Toshimitsu, c/o Roran Co., Osaka (JP)
(74) Representative: Maury, Richard Philip

(57) **Abstract**

In a CPU core development support system for an FPGA or the like, if a user defines information about addition, change and deletion of instructions of assembly language from a customizing screen, an assembler generating compiler generates a source program of an assembler which takes in a new grammatical rule in response to the addition, change and deletion of the instructions into a basic grammatical rule of the assembly language based on the information about addition, change or deletion of the instructions, and the basic grammatical rule of the assembly language. This makes it easier to add, change and delete the instructions of the assembly language, thereby allowing constructing a convenient CPU core in response to specifications of other IPs.

## Description

### BACKGROUND OF THE INVENTION

This invention relates generally to a system for supporting development of a CPU core on a logic integrated circuit which can be re-programmed such as a field programmable gate array (hereinafter referred to as FPGA), a programmable logic device (hereinafter referred to as PLD) and the like that is integrated in an FA device, a communication device, a household electrical appliance, and so forth.

A conventional ASIC (Application Specific IC) has adopted a construction of a system LSI having a CPU core, and a method of processing with a program included in the CPU core for a complicated analytic processing. For supporting development of the CPU core on said ASIC, semiconductor makers have provided development support systems of the CPU core. In some of this kind of development support system, a user can add instructions of the CPU core according to specifications of other IPs (Intellectual Properties) composing the system LSI, and automatically generate a compiler in correspondence with the added instructions.

However, in the development support system of the CPU core on the conventional ASIC, since the user can add only the instructions used in the CPU core, but cannot arbitrarily change or delete the instructions, nor add, change and delete registers in the CPU core, so that the user cannot construct the CPU core in response to specifications of other IPs. Besides, since the user cannot delete registers in the CPU core in said CPU core development support system, if the user construct the CPU core on an FPGA or PLD of a smaller scale circuit than an ASIC by said development support system, the CPU core increases its area on the FPGA or PLD.

### SUMMARY OF THE INVENTION

This invention is made to solve the above-mentioned problems. The first object of the present invention is to provide a CPU core development support system which allows the user to change or delete instructions used in a CPU core, and arbitrarily add, change or delete registers in the CPU core on a logic integrated circuit such as an FPGA, PLD and the like, to thereby make it possible to construct a simple CPU core in response to specifications of other IPs on the logic integrated circuit.

In order to achieve the above-mentioned object, according to one aspect of the present invention, there is provided a CPU core development support system for supporting development of a CPU core on a logic integrated circuit such as a field programmable gate array, comprising: a source program which describes a basic grammatical rule of assembly language which is used in the CPU core; a defining means for defining information about addition, change and deletion of instructions of the assembly language; an assembler generating compiler which generates a source program of an assembler which takes in a new grammatical rule in response to the information about addition, change and deletion of the instructions in the basic grammatical rule of the assembly language based on the source program and the information about addition, change and deletion of the instructions of the assembly language defined by the defining means.

In the above constitution, when there are any IPs other than the CPU core on the logic integrated circuit, and if a user defines the information about addition change and deletion of the instructions of the assembly language in response to specifications of the other IPs on the logic integrated circuit through defining means, the assembler generating compiler generates a source program of an assembler which takes in a new grammatical rule in response to the information about addition, change and deletion of the instructions in the basic grammatical rule of the assembly language based on the source program and the information about addition, change and deletion of the instructions of the assembly language defined by the defining means. This, in the case that there are any IPs other than the CPU core on the logic integrated circuit, allows facilitating the addition, change and deletion of the instructions of the assembly language used in the CPU core in response to specifications of the other IPs.

According to another aspect of the present invention, the CPU core development support system further comprises a simulator for testing the source program in the assembly language describing operations of the CPU core; and wherein the simulator operates in response to the information about addition, change and deletion of the instructions of the assembly language defined by the defining means. Owing to this constitution, if only the user defines the information about addition, change and deletion of the instructions of the assembly language through the defining means in order to generate the source program which takes in new grammatical rules, the simulator interprets and carries out the source program in the assembly language with using the new grammatical rules similar to the assembler generated by the assembler generating compiler.

According to a further aspect of the present invention, the assembler that is created by compiling the source program of the created assembler, separately generates a file composed of label groups of a processing unit in the source program, and a file composed of label groups of a data unit in the source program based on labels defined in the source program by the assembly language when assembling the source program by the assembly language to an object program; and the simulator distinguishes the labels of the processing unit and the labels of the data unit in the source program based on information stored in the two files when simulating the source program created by the assembly language. Owing to this constitution, if the CPU core adopts a hard architecture having data memory and program memory which are separated to each other, the simulator is capable of readily recognizing labels in the source program between a program segment and a data segment, which makes it possible to facilitate interpreting and carrying out the source program.

According to a further aspect of the present invention, there is provided a CPU core development support system for supporting development of a CPU core on a logic integrated circuit such as a field programmable gate array, comprising: a directing means for directing addition, change and deletion of registers in the CPU core; and a renewal means for renewing a source at a hardware description language level of the CPU core based on information about addition, change and deletion of registers in the CPU core directed by the directing means.

In the above constitution, when there are any IPs other than the CPU core on the logic integrated circuit, and if a user defines the information about addition change and deletion of the instructions of the assembly language in response to specifications of the other IPs on the logic integrated circuit through defining means, the renewal means renews the source at the hardware description language level of the CPU core based on the information about addition, change and deletion of registers in the CPU core directed by the directing means. This makes it possible to easily add, change and delete the registers in the CPU cores in response to the specifications of the other IPs. Besides, if there is any unwanted register in the CPU core, and when the user directs to delete the unwanted register through the directing means, the renewal means delete the register from the source at the hardware description language level of the CPU core, thereby allowing easily constructing the simple CPU core on the logic integrated circuit.

According to a further aspect of the present invention, the CPU core development support system, further comprises; a simulator for testing the source program in the assembly language describing operations of the CPU core; and wherein the simulator operates in response to the information about addition, change and deletion of the registers of directed by the directing means. Owing to this constitution, if the user directs to add, change and delete the registers in the CPU core through the directing means in order to renew the source at the hardware description language level of the CPU core, the simulator is capable of interpreting and carrying out the source program including instructions to the registers described in the source of the CPU core that was renewed by the renewal means.

According to a further aspect of the present invention, there is provided a method of supporting a CPU core on a logic integrated circuit such as a field programmable gate array by a programmed computer, comprising steps of: defining information about addition, change and deletion of instructions in assembly language that is used in the CPU core; and generating a source program of an assembler which takes in a new grammatical rule in response to the information about addition, change and deletion of the instructions in the basic grammatical rule of the assembly language based on the source program describing the basic grammatical rule of the assembly language that is used in the CPU core, and the information about addition, change and deletion of the instructions of the assembly language defined by the defining means.

According to a further aspect of the present invention, there is provided a method of supporting development of a CPU core on a logic integrated circuit such as a field programmable gate array by a programmed computer, comprising steps of: directing addition, change and deletion of registers in the CPU core; and renewing a source at a hardware description language level of the CPU core based on addition, change and deletion of registers in the CPU core.

According to a further aspect of the present invention, there is provided a recording medium storing a program for supporting development of a CPU core on a logic integrated circuit such as a field programmable gate array by a computer: wherein the program is for the CPU core development support system.

### BRIEF DESCRIPTION OF THE DRAWINGS

FIG. 1 is a view showing a structure around a CPU core development support system according to one embodiment of the present invention.

FIG. 2 is a block diagram of functions of a CPU core development support tool in said CPU core development support system.

FIG. 3 is a view showing a customizing screen of a CPU core included in said CPU core development support tool.

FIG. 4 is an explanatory view of additional processing of registers in the CPU core employing said CPU core development support tool.

FIG. 5 is a view showing a debugging screen included in said CPU core development support tool.

FIG. 6 is a flowchart showing an entire development processing executed by said CPU core development support system.

FIG. 7 is a structural view for down loading an operating description program and a logic synthesis result to an FPGA, and carrying out an actual CPU core test.

FIG. 8 is a flowchart showing details of customizing processing of the CPU core and offline debugging test for the CPU core performed by said CPU core development support system.

FIG. 9 is a view showing a data flow in the customizing processing for the CPU core performed by said CPU core development support system.

FIG. 10 is a view showing an augmentation processing of a grammatical rule performed by an assembler generating compiler.

FIG. 11 is an explanatory view of a description method of a source program in MC language.

FIG. 12 is a view showing a basic context of MC language.

FIG. 13 is a view showing a source program of an assembler corresponding to a source program indicating a selection of the processing described in MC language.

FIG. 14 is a view showing an example of a simple grammatical rule created in MC language,

FIG. 15 is a view showing a leading part of a source program of an assembler generated based on the source program in MC language shown in FIG. 14.

FIG. 16 is a view showing cal function in the source program of the assembler generated based on the source program in MC language shown in FIG. 14.

FIG. 17 is a view showing getval function in the source program of the assembler generated based on the source program in MC language shown in FIG. 14.

### DETAILED DESCRIPTION OF THE PREFERRED EMBODIMENT OF THE PRESENT INVENTION

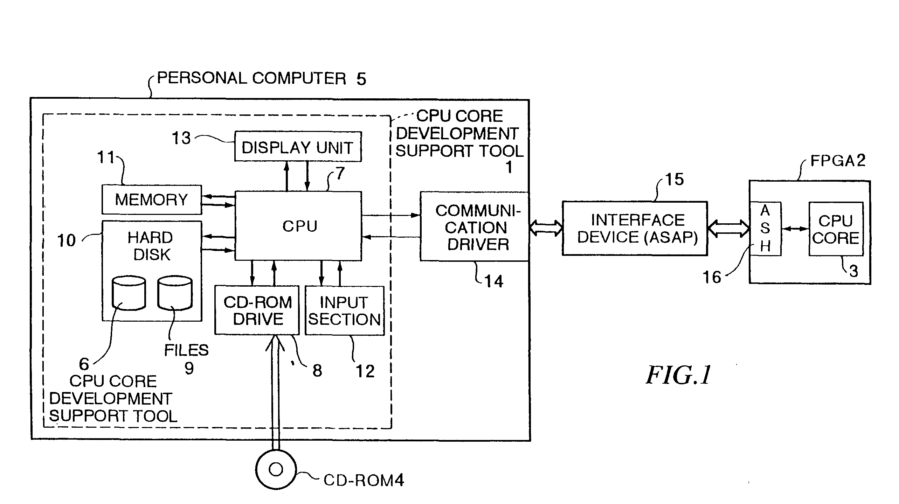

Now, a development-support system for a CPU core according to one embodiment of the present invention is explained with reference to the drawings. FIG. 1 shows the development-support system for a CPU core according to the present embodiment with a structure of a peripheral equipment thereof. A CPU core development support system 1 for supporting development of a CPU core 3 on an FPGA (field programmable gate array) 2 which is a kind of a logic integrated circuit, operates based on a CPU core development support tool 6 which is installed in a personal computer 5 from a CD-ROM 4 (recording medium which records a CPU core development support program in claims). The development support system 1 comprises a CPU 7, a CD-ROM drive 8, a hard disk 10, a memory 11, an input section 12 and a display unit 13, wherein the CPU 7 executes entire control of the personal computer 5, the CD-ROM drive 8 reads out various kinds of programs and data stored in the CD-ROM 4, the hard disk 10 stores the CPU core development support tool 6 or various kinds of files 9, the memory 11 is accessible in high speed for temporarily storing various kinds of programs which are stored in the hard disk 10, the input section 12 consists of a key board, a mouse and so forth, and the display unit 13 consists of a display, a printer and so forth. Further, the personal computer 5 has a communication driver 14 for communication through an RS-232C interface. The communication driver 14 is connected to an interface device 15 (ASAP: Adaptive Scan Agent Pod). The ASAP 15 is equipped with a special-purpose terminal for a boundary scan test, which is called as TAP (Test Access Port), and connected to an ASH (Adaptive Scan Handler) 16 in the FPGA 2. The ASH 16 is a module for transmitting and receiving signals to and from the ASAP 15. Data transmitted from the communication driver 14 of the personal computer 5 is downloaded to the FPGA 2 through the ASAP 15 and ASH 16.

Said CD-ROM 4 includes a source at a VHDL (VHSIC hardware description language: one kind of hardware description language) level as well as the CPU core development support tool 6. Employing the development support system 1, the user can customize the source at the VHDL level of the CPU core 3 which is read out from the CD-ROM 4, adds, changes and deletes instructions which can be used in an operating description program of the CPU core 3, and examines the personal computer 5 (hereinafter referred to as offline debugging) for the operating description program created by themselves. Customized source at VHDL level of the CPU core 3 is downloaded to the FPGA 2 through the communication driver 14, interface device 15 and ASH 16 after logic synthesis. Also, operating description program for which offline debugging is completed, is also downloaded to the FPGA 2 through the same route after assembled.

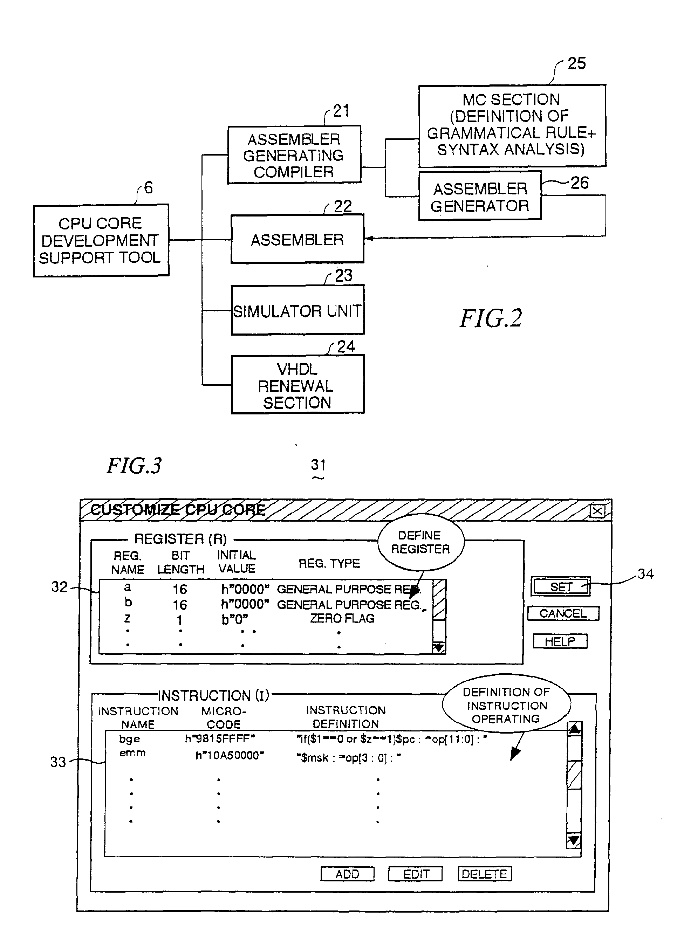

Next, referring to FIG. 2, the explanation is given to the CPU core development support tool 6 (hereinafter referred to as development support tool) which is installed in the personal computer 5 from said CD-ROM 4. The CPU core development support tool 6 comprises a compiler 21, an assembler 22, a simulator section 23 and a VHDL renewal section 24 (renewal means in claims). The compiler 21 (hereinafter, referred to as assembler generating compiler) generates an assembler for a source program in assembly language describing operations of the CPU core 3. The assembler 22 assembles the source program in assembly language describing operations of the CPU core 3. The simulator section 23 is an interpreter for sequentially interpreting and performing the source program describing operations of the CPU core 3 on a step-by-step basis. The VHDL renewal section 24 renews the source at VHDL level of the CPU core 3 based on information directed by the user. Further, the assembler generating compiler 21 comprises an MC (Master C) section 25 and an assembler generator 26. The MC section 25 defines a grammatical rule of assembly language that can be used in operating description program of the CPU core 3, and analyses syntaxes of said grammatical rule. The assembler generator 26 generates a source program of the assembler in C-language according to said grammatical rule based on the syntax analysis of the grammatical rule by the MC section 25. Said assembler 22 is composed of the object program created by compiling the source program of the assembler generated by said assembler generator 26.

Referring to FIG. 3, the customizing processing of the CPU core 3 by means of said development-support tool 6 is nextly explained. In order to customize the CPU core 3, it is generally necessary to change operations of the instructions that can be used in registers in the CPU core 3 or operating description program of the CPU core 3. The development support tool 6 has a screen 31 for customizing the CPU core 3, and the user employs a register defining screen 32 (direction means in claims) and an instruction defining screen 33 (defining means in claims) in said customizing screen 31, thereby customizing registers in the CPU core 3, and instructions of assembly language that can be used in the operating description program of the CPU core 3. In order to customize registers, the user inputs from the register defining screen 23 information about addition, change or deletion of registers (hereinafter referred to as register defining information). Also, in order to customize instructions of assembly language, the user inputs from the instruction defining screen 33 information about addition, change or deletion of the assembly language (hereinafter referred to as instruction defining information). After the user finishes inputting these defining information, and clicks a setting button 34 through a mouse included in the input section 12 shown in FIG. 1, the VHDL renewal section 24 shown in FIG. 2 renews the source of VHDL level of the CPU core 3 based on these defining information, and besides, the assembler generating compiler 21 generates a source program of the assembler 22 based on these defining information. Further, the simulator section 23 gets in an available state for operation based on these defining information.

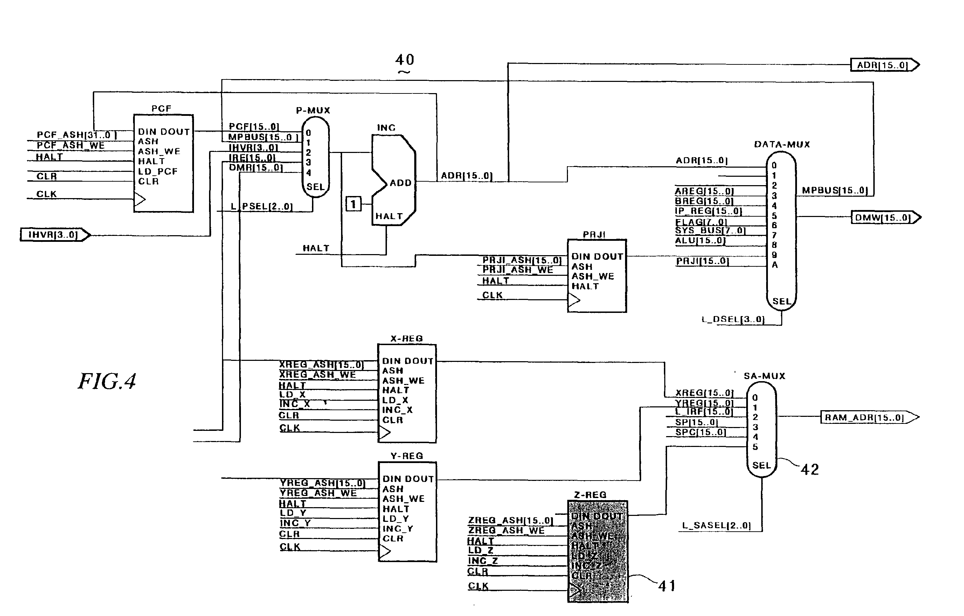

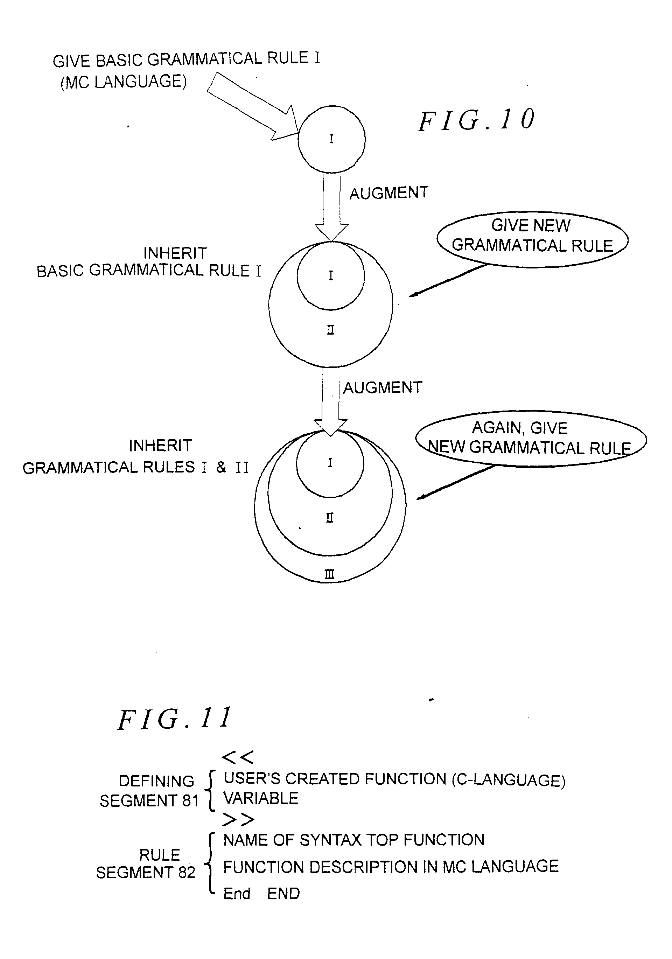

Then, with reference to FIG. 4 as well as above FIG. 3, customizing processing of the CPU core 3 is explained with showing a specific example. As shown in FIG. 4, in the case of adding a new register Z-REG 41 to a data path 40 of the CPU core 3, and at the same time adding an LDZ (load Z register) instruction which loads data to said Z-REG 41, it is necessary to change contents of an SA-MUX 42 as a multiplexer. In this case, if only the user inputs information for adding the Z-REG 41 from the register defining screen 32, and inputs information for adding the LDZ instruction from the instruction defining screen 33, the VHDL renewal part 24 adds the Z-REG 41 into the source at VHDL level of the CPU core 3, and changes contents of the SA-MUX 42 based on these information. Also, the assembler generating compiler 21 generates assembler that new grammatical rules are taken in correspondence with the addition of the Z-REG 41 and LDZ instruction, based on information of adding the Z-REG 41 and LDZ instruction that are respectively input from the register defining screen 32 and instruction defining screen 33. In accordance with this, the Z-REG 41 and LDZ instruction can be used in the simulator section 23. In order to input information for adding the LDZ instruction from the instruction defining screen 33, the operation is defined by employing simplified language known as MC (master C) language (refer to FIGS. 11 - 14). In said MC language, only the register that is displayed in the register definition screen 32 can be used.

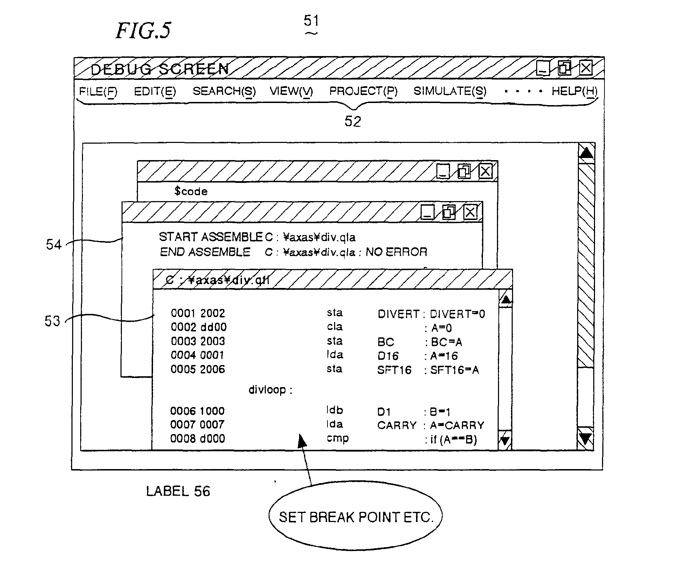

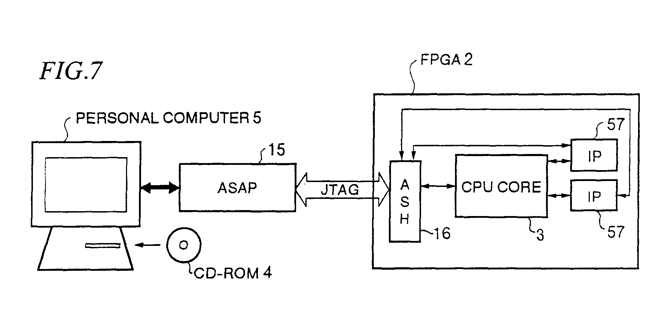

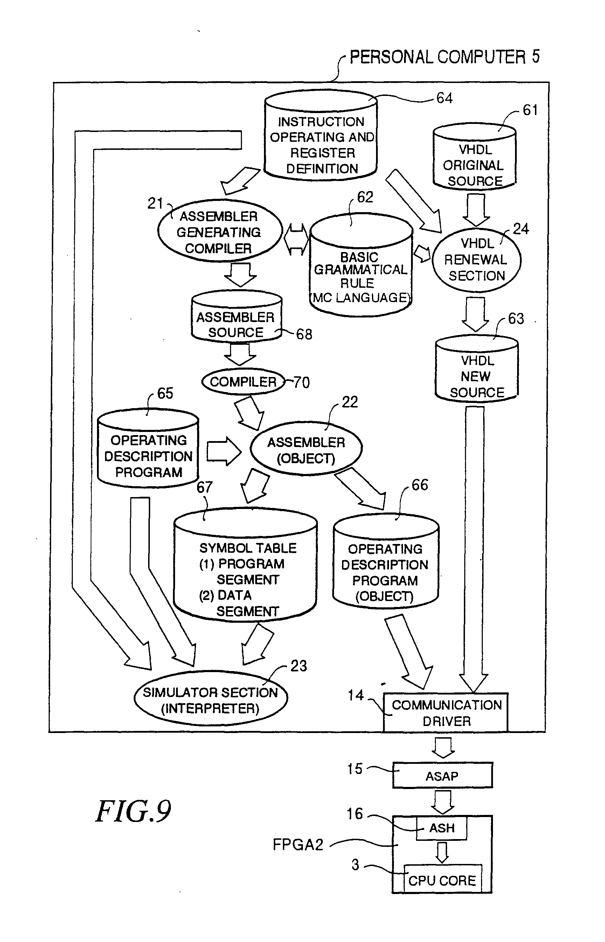

Referring to FIG. 5, the explanation is nextly given to offline debugging processing for the operating description program of the CPU core 3 through the simulator section 23 shown in FIG. 2. The simulator section 23 has a debugging screen 51, wherein the user invokes a debugger set screen 53, an assembling direction screen 54, and an editor screen (not shown) and the like from a pull-down menu 52 of the debugging screen 51, and carry out processing such as a direction for the debugger (e.g., setting of a break point), correction of the operating description program of the CPU core 3, assembly of the corrected operating description program and so forth. Further, the user can debug the operating description program by sequentially interpreting and executing the operating description program in step-by-step with the interpreter included in the simulator section 23. Functions as a debugger included in the simulator section 23 are basically similar to functions of a normal debugger such as setting of a break point, tracing, a memory dump, memory rewriting and so forth. However, the point which is different from functions of the normal debugger is that the user can simulate input from another IP 57 (refer to FIG. 7) in the FPGA 2 in the debugging processing of the present embodiment. Consequently, using the simulator section 23, the user can examine the data generated in the CPU core 3 from the IP 57. Furthermore, if the user directs to assemble the operating description program from the assembling direction screen 54, the assembler 22 classifies the label 56 in the operating description language program into labels of a program segment and a data segment, and creates a symbol table 67 (refer to FIG. 9) which consists of sets of labels for each of segments. The simulator section 23 refers to the symbol table 67, thereby easily distinguishing between labels of the program segment and data segment when the interpreter interprets the operating description program. As described above, it should be noted that the simulator section 23 operates based on information input from the register defining screen 32 and instruction defining screen 33 shown in FIG. 3.

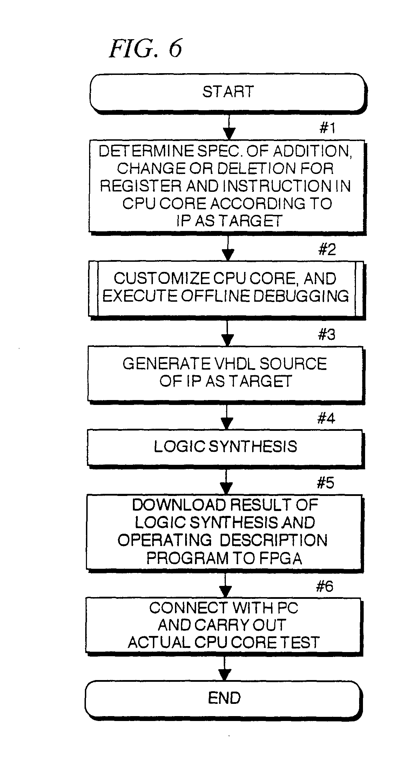

Next, with reference to FIGS. 6 and 7, the explanation is given to the entire development processing of the CPU core 3 by the CPU core development support system 1 according to the present invention. Being different from a conventional CPU core development support system in an ASIC and the like, the development support system 1 according to the present invention aims to customize the CPU core 3 according to specifications of various kinds of the IPs 57 on the FPGA 2, and examine the CPU core 3 according to customized contents. Functions required in the CPU core 3 generally differ in response to specifications of the IPs 57 as targets. Accordingly, it is preferrable to change the architecture and operating description program of the CPU core 3 in response to the IPs 57 on the FPGA 2. Also, if the architecture and operating description program of the CPU core 3 are changed, it is necessary to change specifications of assembly language for the operating description program and the assembler for said assembly language. The development support system 1 makes it possible to customize and examine the CPU core 3 in response to specifications of the IPs 57. Concretely explaining, the user first determines registers in the CPU core 3, and specifications of addition, change and deletion of instructions (#1), and then, in response to the specifications, customizes registers of the CPU core 3, and instructions of the assembly language from the customizing screen 31 shown in FIG. 3, besides carries out the offline debugging for the operating description program from the debugging screen 51 shown in FIG. 5 in response to specifications of the customized registers and instructions of assembly language (#2). Next, the user creates the source at VHDL level of the IPs 57 as targets (#3), and executes logic synthesis of the source of said IPs 57 and the source at VHDL level in the CPU core 3 renewed by the VHDL renewal section 24 (#4). Then, as shown in FIG. 7, the user connects the FPGA 2 with the personal computer 5 through the ASAP 15, and downloads the object program of the operating description program which is debugged in offline in #2, and the result of logic synthesis in #4 to the FPGA 2 (#5). Next, the user carries out an actual CPU core 3 test (online debug) on the FPGA 2 by transmitting and receiving data to and from the CPU core 3 on the FPGA 2 from the personal computer 5 in a state that the personal computer 5 and the FPGA 2 are connected with each other (#6).

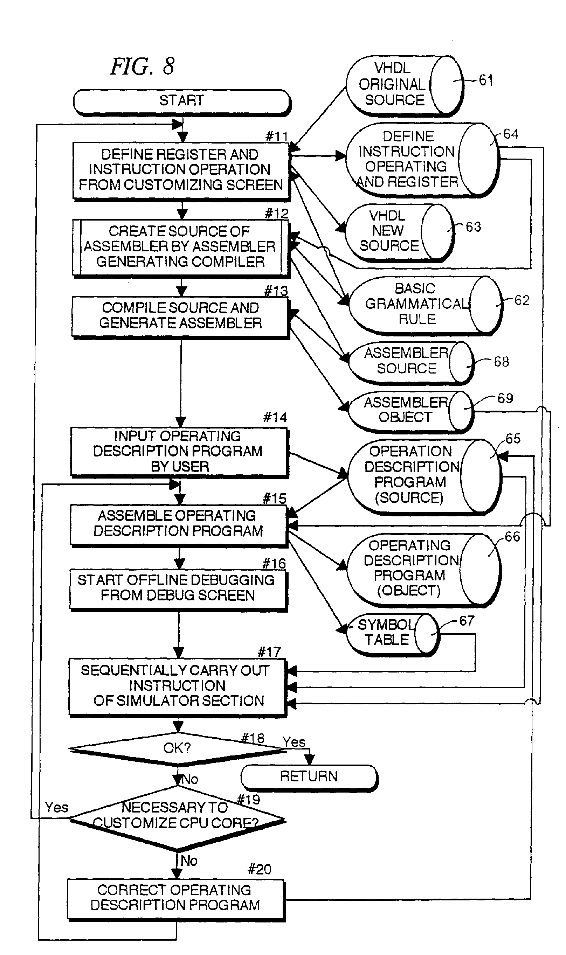

Referring to FIG. 8, the explanation is given to details of customization and offline debugging procedure of the CPU core 3 in #2 in FIG. 6. When the user displays the customizing screen 31 shown in FIG. 3, the CPU core development support tool 6 displays register defining information in response to contents of a file (hereinafter referred to as VHDL original source file) 61 which stores VHDL source (VHDL source read out from the CD-ROM 4 in an initial state) of the present CPU core 3. Further, the instruction defining screen 33 displays instruction defining information in response to a file (hereinafter referred to as basic grammatical rule file) 62 storing basic grammatical rule (source of basic grammatical source in the assembly language read out from the CD-ROM 4 in an initial state) of the assembly language for the present operating description program. After the user completes definitions of registers and the instruction of the assembly language through the register defining screen 32 and the instruction defining screen 33 (#11), the CPU core development support tool 6 creates an instruction operating and register defining file 64 storing these defining information, and at the same time creates a file (hereinafter referred to as VHDL new source file) 63 of VHDL source in the new CPU core 3 which reflects these defining information. The assembler generating compiler 21 in the CPU core development support tool 6 generates an augmented grammatical rule which embodies new grammatical rule in the basic grammatical rule of the assembly language in response to defining contents of new registers and instructions of assembly language, and changes the contents of the basic grammatical rule file 62 into said augmented grammatical rules, and at the same time, generates a source program of the assembler corresponding to said augmented grammatical rule (#12). After that, it stores the created source program into an assembler source file 68. The user compiles said assembler source, thereby obtaining an object program of a desired assembler which embodies a new grammatical rule (#13). Said object program of the assembler is stored as an assembler object file 69 in the hard disk 10 shown in FIG. 1.

If the user inputs the source of operating description program of the CPU core 3 (#14), and assembles said source of the operating description program in the assembler 22 stored in the assembler object file 69 (#15), the assembler 22 creates an object file 66 of operating description program, and at the same time, outputs the symbol table 67 for offline debugging based on various kinds of the labels 56 (refer to FIG. 5) in the source of the operating description program. Next, using the debugging screen 51, the user starts the offline debugging (#16), and using the interpreter function of the simulator section 23, carries out each of instructions in a source file 65 in operating description program in step-by-step (#17), and then, carries out the operating description program. After that, if the examined result of the operating description program includes a problem (NO in #18), and it is necessary to customize the CPU core 3 (YES in #19), the procedure from #11 to #17 is repeated. If it is not necessary to customize the CPU core 3, and the problem can be solved by correcting operating description program (NO in #19), after the user invokes an editing screen from the customizing screen 31, and corrects the operating description program in said editing screen (#20), the procedure from #15 to #17 is repeated.

Next, referring to FIG. 9, the explanation is given to data flows in the customizing procedure of said CPU core 3. In the figure, it is to be noted that the same components as the previously-mentioned ones are denoted by the same reference numerals. If, using the register defining screen 32 and instruction defining screen 33 shown in FIG. 3, the user customizes registers and instructions of assembly language, and creates the instruction operating and register defining file 64, the assembler generating compiler 21 generates an augmented grammatical rule which embodies a new grammatical rule, based on the instruction operating and register defining file 64 and basic grammatical rule file 62, and rewrites the contents of the basic grammatical rule file 62 into the augmented grammatical rule; and at the same time, generates a source program of the assembler in response to said grammatical rule, and outputs it as the assembler source file 68. Based on said assembler source file 68, a compiler 70 outputs the assembler's object program (hereinafter simply referred to as assembler) 22. Based on the source file 65 of operating description program created by the user, said assembler 22 creates the file 66 which stores the object program of said operating description program, and at the same time, classifies the label 56 in the source of the operating description program into the label 56 of the program segment and the label 56 of data segment, to thereby create the symbol table 67 consisting of sets of the label 56 at every segment. The simulator section 23 operates based on said symbol table 67, instruction operating and register defining file 64 and source file 65 of operating description program. After completing the offline debugging by means of the simulator section 23, if the user directs to download the contents of the operating description program (object) file 66 into the FPGA 2, the CPU 7 of the personal computer downloads the result of the logic synthesis into the FPGA 2 through the communication driver 14, ASAP 15 and ASH 16 in the FPGA 2. Further, based on the instruction operation and register defining file 64, the VHDL renewal section 24 renews the contents of the VHDL original source file 61 corresponding to the circuit of the CPU core 3, thereby creating a VHDL new source file. If the user logically synthesizes the contents of the new source file 63 by using a logic synthesis tool presented by an FPGA maker, and directs to download the result of the logic synthesis to the FPGA 2, the CPU 7 in the personal computer downloads the result of the logic synthesis to the FPGA 2 through the communication driver 14, ASAP 15 and ASH 16 in the FPGA 2. Thus, using the communication driver 14 and the like, the user downloads the circuit of the new CPU core 3 and the operating description program of the CPU core 3 into the FPGA 2, thereby making it possible to construct the CPU core 3 on the FPGA 2, and start the online debugging for the CPU core 3.

Next, referring to FIG. 10, augmentation processing of grammatical rule performed by the assembler generating compiler 21 is explained. If the user adds a new grammatical rule of assembly language from the customizing screen 31 shown in FIG. 3, the assembler generating compiler 21 generates a new augmented grammatical rule II which embodies a new grammatical rule after inheriting and succeeding a basic grammatical rule I of the assembly language in MC language that is read from the basic grammatical rule file 62. Further, if the user adds a new grammatical rule of the assembly language from the customizing screen 31, the assembler generating compiler 21 generates a re-augmented grammatical rule III which embodies the new grammatical rule after inheriting and succeeding the previously-given grammatical rules I and II. Thus, if the user adds the new grammatical rule, the assembler generating compiler 21 augments the grammatical rule so as to embody the new grammatical rule after inheriting and succeeding the previously-given grammatical rule, to thereby generate the source program of assembler 22 corresponding to the augmented grammatical rule. The user compiles the source program, thereby obtaining assembler 22 that corresponds to the augmented grammatical rule.

The grammatical rule stored in said basic grammatical rule file 62 is created in MC language that is simplified language in a description form similar to BNF (Buckus Normal Form). Based on the source program of the basic grammatical rule of the assembly language described in MC language read out from the basic grammatical rule file 62, and new grammatical rule input from the customizing screen 31 by the user, the assembler generating compiler 21 generates the source program of the augmented grammatical rule in MC language, and renews the contents of the basic grammatical rule file 62 into the source program of said augmented grammatical rules, and at the same time, converts the source program described in MC language into the source program of the assembler 22 described in C language. The assembler generating compiler 21 reads the renewed basic grammatical rule file 62, and extracts a literal train as a token in a line-by-line, and creates a function of the assembler 22 in C language according to the rule of MC language.

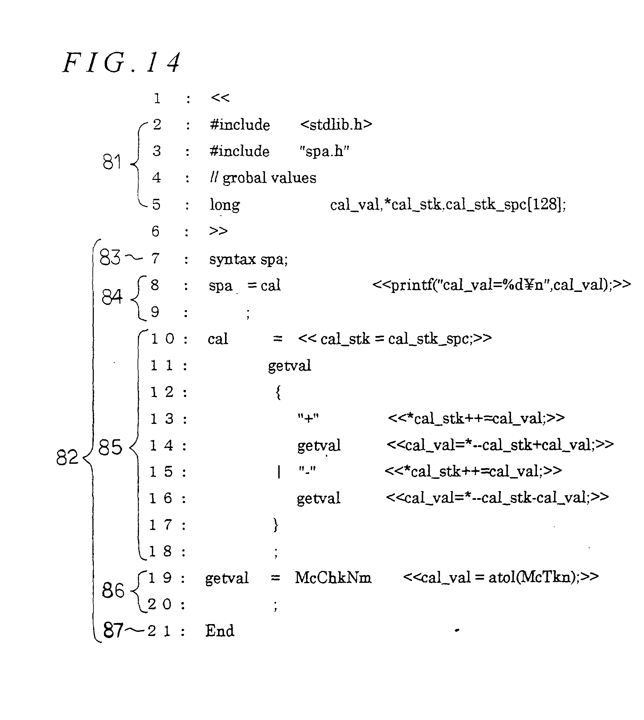

Next, referring to FIG. 11, a description method of the source program of the grammatical rule in MC language is explained. When the user describes the source program in MC language, it is necessary to describe the source program separately into a defining segment 81 and a rule segment 82, and describe "End" in the end of a sentence. The description method and grammar of the defining segment 81 are same as in the case of C language. The user describes variables used in the rule segment 82, definition such as prototype declaration, or functions created by the user and used in the rule segment 82, into the defining segment 81 in C language. The assembler generating compiler 21 outputs the described contents in said defining segment 81 as they are, into the source program of the assembler 22. Besides, the user is required to describe the rule segment 82 in MC language. The function in MC language described in the rule segment 82 is converted into the function in C language by the assembler generating compiler 21, and output into the source program of the assembler 22. The user has to define a top function created in MC language in a syntax sentence in the top of the rule segment 82, and describe an End sentence in the end. In the case of the source program shown in FIG. 14, sections from 83 to 87 correspond to the rule segment 82.

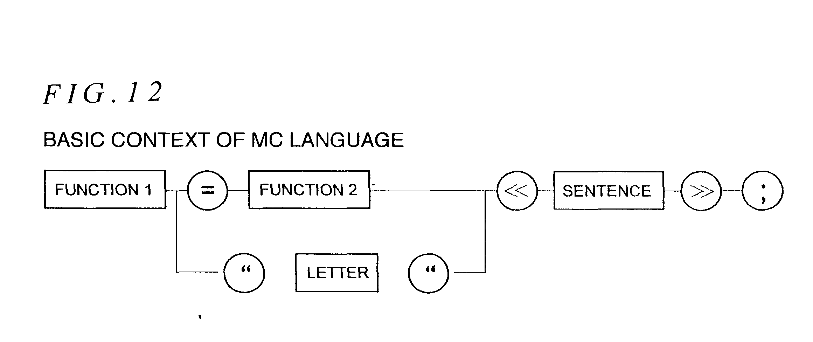

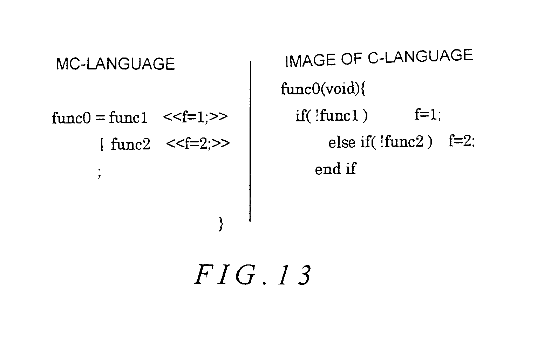

Referring to FIG. 12, a basic context in MC language is explained. In the basic context in MC language, a left side is a name of a function while a right side means processing of said function. As shown in the figure, the user describes function 1 in the left side, to thereby define contents of function 1. The contents of an upper side of the basic context in the figure indicates that, executing function 1 performs function 2, and when a return value of function 2 is 0, contents of <<sentence>> is performed. The contents of a lower side indicates that, instead of processing by function 2, comparison processing between a literal train ("letter") which is enclosed by double quotation marks and an input token is carried out, and the contents of <<sentence>> is also performed even in the case that these are same as each other. This is because the contents that are enclosed by double quotation marks are processed as a literal train comparing function. Also, the contents of <<sentence>> is described in C language, and output as they are by the assembler generating compiler 21 in the source program of the assembler 22. The user omits the description of function 2 in the upper side of the basic contexts, thereby making it possible to unconditionally output the contents of <<sentence>> in the source program of the assembler 22. Besides, the end of function 1 is indicated by ";" as shown in the figure. Following the definition of function 1 using function 2, the user describes the definition of function 2 using function 3, and further describes the definition of function 3 using function 4. In such a way of hierarchically describing the processing of functions one after another, it is possible to express the grammatical rule of the desired assembly language. Return values of each of functions are determined as 0 = normal finish, and 1 = error, so that the user has to create the functions according to this rule. Besides, the user can describe so as to correspond to selected processing by separating the processing with "| " marks for describing plural functions in parallel. For example, as shown in FIG. 13, the user can describe selecting processing between "func1 <<f=1;>>" and "func2 <<f=2;>>" by describing the "|" mark before func2.

Parenthesis marks and their meaning which can be used in the rule segment 82 in FIG. 11 are as follows:
[1] {}: Repeat {} processing
[2] []: Ignore return from [] processing
[3] <<>>: Output <<>> processing into the source program of the assembler 22 as they are
[4] "": Compare between a literal train enclosed by "" and a token

The assembler generating compiler 21 has various kinds of normal functions that can be used in the rule segment 82 in FIG. 11. In the rule segment 82, the user can define the grammatical rule of the assembly language by using these normal functions. Some of these normal functions and their capabilities are indicated below:
[1] McChkRsv(char^{*}): Compare between input buffer and a specified literal train. Input pointers are not renewed.
[2] McChkNm(void): Input a literal train in decimal numbers, and check whether the input train is numerals or not. Spaces between tokens are automatically omitted to be read, and input pointers are renewed.
[3] McStop(char^{*}): Display an error message, and finish processing in case that an error occurs. Input pointers are renewed.

Next, referring to FIG. 14, an example of a simple grammatical rule created in MC language is explained. "<<" in the No. 1 line and ">>" in the No.6 line respectively indicate starting positions of the defining segment 81 and rule segment 82, and the No.2 to No.5 lines in the source program correspond to the defining segment 81, and the No.7 to No.21 lines correspond to the rule segment 82. Also, the rule segment 82 comprises the syntax sentence 83, top function defining sentence 84, cal-function defining sentence 85, getval-function defining sentence 86 and End sentence 87. The grammatical rule of the source program only permits additions and subtractions, and performs additions and subtractions based on input numerals, and "+" and "-" marks. If no error occurs, a result of the calculation is displayed.

Next, the explanation is given to processing of each of steps performed in the rule segment 82 in the source program shown in said FIG. 14.
Line 7: Specify spa as a top function by a syntax sentence.
Line 8: Defining processing of a top function spa. Concretely, after the spa function is executed, cal function is invoked, and if a return value of it is 0, contents of a cal_val variation are displayed.
Line 9: Terminate the spa function.
Lines 10 - 17: Defining processing of a cal function. Concretely, after the cal function is executed, the top address of a cal_stk_spc array is set on a cal_stk pointer (line 10), and a getval function (function for reading numeric into the cal_val variation) is invoked (line 11). Then, if a next letter is "+", the value of the cal_val variation is saved in a ^{*}cal_stk area (line 13), and the getval function is again invoked. If return value of it is 0, the value of the cal_val variation is added to the value of cal_stk area (line 14). On the other hand, if the next letter is "-", the value of the cal_val variation is saved in a ^{*}cal_stk area (line 15), and the getval function is again invoked. If the return value of it is 0, the value of the cal_val variation is subtracted from the value of the ^{*}cal_stk area (line 16). After that, the processing from lines from 13 to 16 is repeated until the termination of input.
Line 18: Terminate the cal function.
Line 19: Defining processing of a getval function. Concretely, after the getval function is executed, McChkNm function is invoked, and it is checked whether input letter is numeral or not. If it is numeral, a numerical value is read in the cal_val variation.
Line 20: Terminate the getval function.
Line 21: Terminate the rule segment 82.

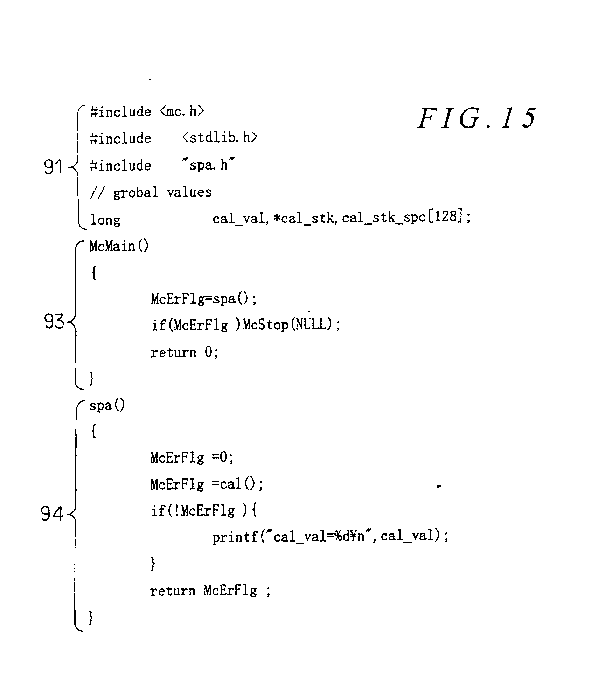

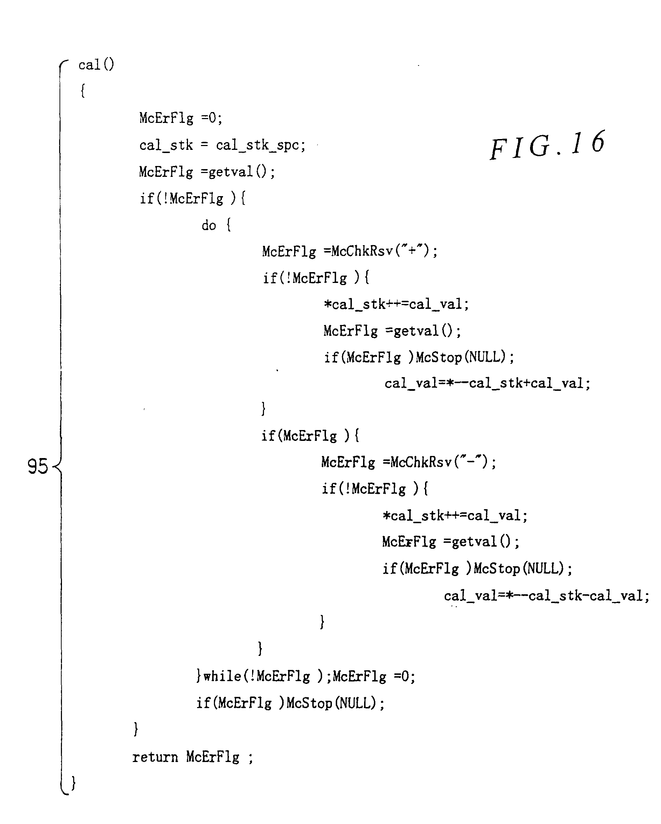

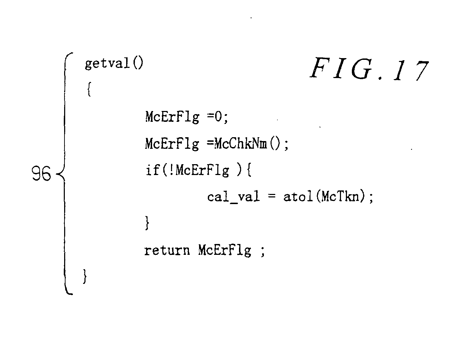

Based on the source program in MC language shown in FIG. 14, the assembler generating compiler 21 generates the source program of the assembler 22 in C-language shown in FIGS. 15 - 17. The defining segment 81 in FIG. 14 corresponds to a working section 91 in FIG. 15, and defining sentences 83 - 86 in FIG. 14 respectively correspond to functions 93 - 96 in FIGS. 15 - 17. Thus, the assembler generating compiler 21 generates the source program of the assembler 22 in response to the grammatical rule given by the user in MC language.

As described above, according to the CPU core development support system 1 of the present embodiment, based on the source program in MC language describing the basic grammatical rule of assembly language that can be used in the CPU core 3, and information about addition, changes or deletion of instructions of the assembly language input from the instruction defining screen 33, the assembler generating compiler 21 generates the source program of the assembler 22 in which the new grammatical rule is taken in the basic grammatical rule of the assembly language in correspondence to information about addition, changes and deletion of the instructions. Thus, the instructions of the assembly language that is used in the CPU core 3 can be added, changed or deleted in accordance with the specifications of other IPs 57 in the FPGA 2. Further, based on information about addition, change or deletion of the registers in the CPU core 3 that is directed by the user, VHDL renewal section 24 renews the VHDL source of the CPU core 3, thereby making it possible to easily add, change and delete the registers in the CPU core 3 in accordance with the specifications of other IPs 57 of the FPGA 2. This allows to easily construct the CPU core 3 in response to the specifications of other IPs 57. Also, if there is any unwanted register in the CPU core 3, the register can easily be deleted from the source in the hardware description language level of the CPU core 3, so that the simple CPU core 3 can be constructed on the FPGA 2.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims. Although the above embodiment explained an example that an additional grammatical rule is given from the customizing screen 31, it is also possible to directly define an additional grammatical rule in MC language, and generate the source program of the assembler 22 in which the new grammatical rule is taken, based on said added grammatical rule and a grammatical rule stored in the basic grammatical rule defining file 62.

## Claims

1. A CPU core development support system for supporting development of a CPU core on a logic integrated circuit such as a field programmable gate array, comprising:
a source program which describes a basic grammatical rule of assembly language which is used in the CPU core;
a defining means for defining information about addition, change and deletion of instructions of the assembly language;
an assembler generating compiler which generates a source program of an assembler which takes in a new grammatical rule in response to the information about addition, change and deletion of the instructions in the basic grammatical rule of the assembly language based on the source program and the information about addition, change and deletion of the instructions of the assembly language defined by the defining means.

2. The CPU core development support system according to claim 1, further comprising:
a simulator for testing the source program in the assembly language describing operations of the CPU core; and
wherein the simulator operates in response to the information about addition, change and deletion of the instructions of the assembly language defined by the defining means.

3. The CPU core development support system according to claim 2;
wherein the assembler that is created by compiling the source program of the created assembler, separately generates a file composed of label groups of a processing unit in the source program, and a file composed of label groups of a data unit in the source program based on labels defined in the source program by the assembly language when assembling the source program by the assembly language to an object program; and
wherein the simulator distinguishes the labels of the processing unit and the labels of the data unit in the source program based on information stored in the two files when simulating the source program created by the assembly language.

4. A recording medium storing a program for supporting development of a CPU core on a logic integrated circuit such as a field programmable gate array by a computer:
wherein the program is for the CPU core development support system claimed in claim 1.

5. A CPU core development support system for supporting development of a CPU core on a logic integrated circuit such as a field programmable gate array, comprising:
a directing means for directing addition, change and deletion of registers in the CPU core; and
a renewal means for renewing a source at a hardware description language level of the CPU core based on information about addition, change and deletion of registers in the CPU core directed by the directing means.

6. The CPU core development support system according to claim 5, further comprising;
a simulator for testing the source program in the assembly language describing operations of the CPU core; and
wherein the simulator operates in response to the information about addition, change and deletion of the registers of directed by the directing means.

7. A recording medium storing a program for supporting development of a CPU core on a logic integrated circuit such as a field programmable gate array by a computer:
wherein the program is for the CPU core development support system claimed in claim 5.

8. A method of supporting a CPU core on a logic integrated circuit such as a field programmable gate array by a programmed computer, comprising steps of:
defining information about addition, change and deletion of instructions in assembly language that is used in the CPU core; and
generating a source program of an assembler which takes in a new grammatical rule in response to the information about addition, change and deletion of the instructions in the basic grammatical rule of the assembly language based on the source program describing the basic grammatical rule of the assembly language that is used in the CPU core, and the information about addition, change and deletion of the instructions of the assembly language defined by the defining means.

9. A method of supporting development of a CPU core on a logic integrated circuit such as a field programmable gate array by a programmed computer, comprising steps of:
directing addition, change and deletion of registers in the CPU core; and
renewing a source at a hardware description language level of the CPU core based on addition, change and deletion of registers in the CPU core.
